# EUROPEAN PATENT APPLICATION

(11) **EP 1 318 208 A2**
(43) Date of publication of application: **11.06.2003**
(21) Application number: 02255286.3
(22) Date of filing: 29.07.2002
(51) Int. Cl.: C23C 14/34, C23C 14/14

(54) **Method of depositing heusler alloy thin film by co-sputtering**

(30) Priority: 07.12.2001 KR 2001077421
(71) Applicant: SAMSUNG ELECTRONICS CO., LTD., Suwon-City, Kyungki-do (KR)
(72) Inventor: Kim, Kee-won,, Seocheon-gun Chungcheongnam-do 325-903 (KR); Park, Wan-jun, Gangnam-gu, Seoul (KR); Kim, Tae-wan, Anyang-city, Kyungki-do (KR); Song, I-hun, 509-703 Puleun Maeul Ssangyong Apt., Seongnam-city, Kyungki-do (KR); Park, Sang-jin, Pyeongtaek-city, Kyungki-do (KR)
(74) Representative: Kyle, Diana

(57) **Abstract**

A method of manufacturing a Heusler alloy thin film by co-sputtering is provided. The Heusleralloy thin film has a general structure formula X2YZ or XYZ by co-sputtering using a deposition apparatus having a substrate placed on a substrate holder in a chamber and targets positioned on a target bracket spaced apart from the substrate. Components of the Heusler alloy thin film are placed on the target bracket as one of single targets and binary alloy targets. Thus, it is easy to manufacture a Heusler alloy thin film having excellent magnetic characteristics.

## Description

The present invention relates to a method of depositing a Heusler alloy thin film, and more particularly, to a method of forming a Heusler alloy thin film having a more improved property by depositing materials constituting the Heusler alloy thin film by co-sputtering at the same time.

A magnetic random access memory (MRAM) is one of nonvolatile memory devices, which is a solid magnetic memory using a magnetoresistance effect based on a particular spin dependence conduction phenomenon of a nano magnetic. This MRAM uses a giant magnetoresistance phenomenon which occurs because a spin that is degree of freedom of electrons has a great effect on an electron transmission, or a tunnel magnetoresistance phenomenon.

The giant magnetoresistance refers to a phenomenon in which differences in resistance occur when the spin between ferromagnetic substances in an arrangement of ferromagnetic substance/metal nonmagnetic substance/ferromagnetic substance is equally and oppositely arranged. The tunnel magnetoresitance refers to a phenomenon in which transmission of current is easier when the spin is equally arranged on two ferromagnetic layers in an arrangement of ferromagnetic substance/insulator/ferromagnetic substance than when the spins is oppositely arranged. In the case of the MRAM using the giant magnetoresistance phenomenon, the difference in resistance values due to magnetization directions is relatively small and thus the difference in voltage values cannot be great. Also, the size of a MOSFET which is combined with a GMR layer to constitute a cell has to be large. Thus, a study on practical use of the MRAM using a TMR layer has been more active.

It is very important to realize a magnetoresistant device having a high magnetoresistance (MR) rate in such MRAM. It is generally known that MR rate is directly related to spin polarization of a magnetic thin film. It is known that about 60% MR rate of CoFe is the currently greatest value. In 1980s, 100% spin polarization in which the spin of electrons contributing to conduction in a Heusler alloy exists only in one direction had theoretically been foreseen and proven in a test. Many attempts to apply such characteristic to spintronics devices have been made but it was very difficult to make Heusleralloy into a thin film.

In general, Heusler alloy is deposited by sputtering, using molecular beam epitaxy (MBE) or in a state that a chip is placed on a target. However, this conventional method of manufacturing a Huesler alloy thin film is inefficient due to difficulties in productivity and problems relating to control of the composition. The efficiency of sputtering is widely accepted when depositing a general alloy thin film. However, Heusleralloy has a fragile characteristic and thus it is difficult to manufacture Heusler alloy as targets.

To solve the above-described problems, it is an object of the present invention to provide a method of efficiently manufacturing a Heusler alloy thin film which is applicable to a TMR cell structure of a MRAM.

Accordingly, to achieve the above object, there is provided a method of manufacturing a Heusler alloy thin film having a general structure formula X2YZ or XYZ by co-sputtering using a deposition apparatus having a substrate placed on a substrate holder in a chamber and targets positioned on a target bracket spaced apart from the substrate. Here, components of the Heusler alloy thin film are placed on the target bracket as one of single targets and binary alloy targets.

The substrate holder is preferably maintained at a temperature of about 200 - 500°C. The chamber is preferably maintained in a vacuum of 10⁻² - 10⁻³ Torr.

The above object and advantages of the present invention will become more apparent by describing in detail preferred embodiments thereof with reference to the attached drawings in which:
FIGS. 1A and 1B are a schematic cross-sectional view and a plan view of a sputtering system used in depositing a Heusler alloy thin film according to the present invention;
FIGS. 2A through 2D are graphs of magnetic characteristics measured with VSM with respect to a Heusler alloy thin film manufactured by changing temperature of a substrate according to the present invention;
FIGS. 3A and 3B are graphs of magnetic characteristics measured on the basis of substrate temperatures with respect to a Heusler alloy thin film manufactured by changing temperature of a substrate according to the present invention; and
FIG. 4 is a graph showing X-ray diffraction measured with respect to a Heusler alloy thin film manufactured by changing temperature of a substrate according to the present invention.

In a method of manufacturing a Heusler alloy thin film by co-sputtering according to the present invention, each of components constituting the Heusler alloy thin film is sputtered as a single target.

A general structure formula of Heusler alloy is X2YZ. Here, X is a metal such as Co or Cu, Y is Mn, and Z is a nonmagnetic substance such as Al, Si, Ga, Ge, Sn, or Sb of a 3A group or 4A group. Also, there is semi-Heusleralloy such as PtMnSb or NiMnSb having a structure formula of XYZ.

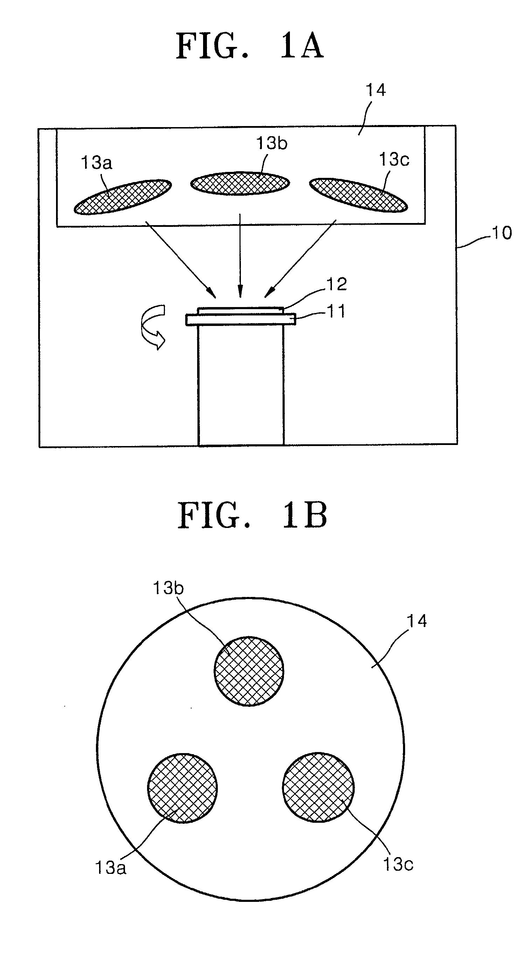

A method of manufacturing a Heusler alloy thin film will be described with reference to FIGS. 1A and 1B. FIG. 1A is a schematic cross-sectional view of a sputtering system used in a process of manufacturing a Heusleralloy thin film by co-sputtering according to the present invention. FIG. 1 B is a plan view of each single target that is components constituting a Heusleralloy thin film and placed on a target bracket. Components constituting a Heusleralloy thin film, e.g., Cu, Mn, Al targets 13a, 13b, and 13c, are placed on a target bracket 14 in a chamber 10 of a sputtering system. A CuMnAI alloy is deposited on a substrate 11 after deposition conditions are set based on the components. Here, the CuMnAI alloy may be formed of one of binary alloys such as CuMn, CuAl, or MnAI and one of Cu, Mn, and Al.

To deposit the components of the Heusleralloy thin film, a general sputtering apparatus and a discharging gas may be used with controlling deposition rate.

An embodiment of a method of manufacturing a Heusler alloy thin film according to the present invention will be described in more detail.

First, single targets 13a, 13b, and 13c constituting a Heusler alloy thin film are deposited on a target bracket 14. A substrate 12 is placed on a substrate holder 11. Here, the inside of a chamber 10 of the sputtering system is maintained in a predetermined vacuum. Such inside vacuum is generally about 7 × 10⁻¹⁰ Torr. A discharging gas, e.g., Ar, is supplied into the chamber 10. Here, vacuum is within a range of 10⁻³ ― 10⁻² Torr. A vacuum pump and a discharging gas supply apparatus operate to maintain a predetermined vacuum. The substrate 12 is maintained at a temperature of about 200 - 500 °C, and the substrate holder 11 rotates at a predetermined speed. Here, the distance between the substrate 12 and the targets 13a, 13b, and 13c may depend on kinds of sputtering systems, and is generally within and without a range of 5 - 20 cm. This process is the same as a general sputtering process.

A voltage is applied between the substrate holder 11 and the target bracket 14 to make the discharging gas into plasma. As a result, components constituting the Heusleralloy thin film are deposited on the substrate 12. Here, deposition rate of Cu is 83 Å/min, deposition rate of Mn is 44 Å/min, and deposition rate of Al is 57 Å/min. In the method of manufacturing a Heusleralloy thin film according to the present invention, a Heusleralloy thin film having excellent characteristics can be formed if deposition rates of components of the Heusler alloy thin film are low. This may depend on kinds of sputtering systems.

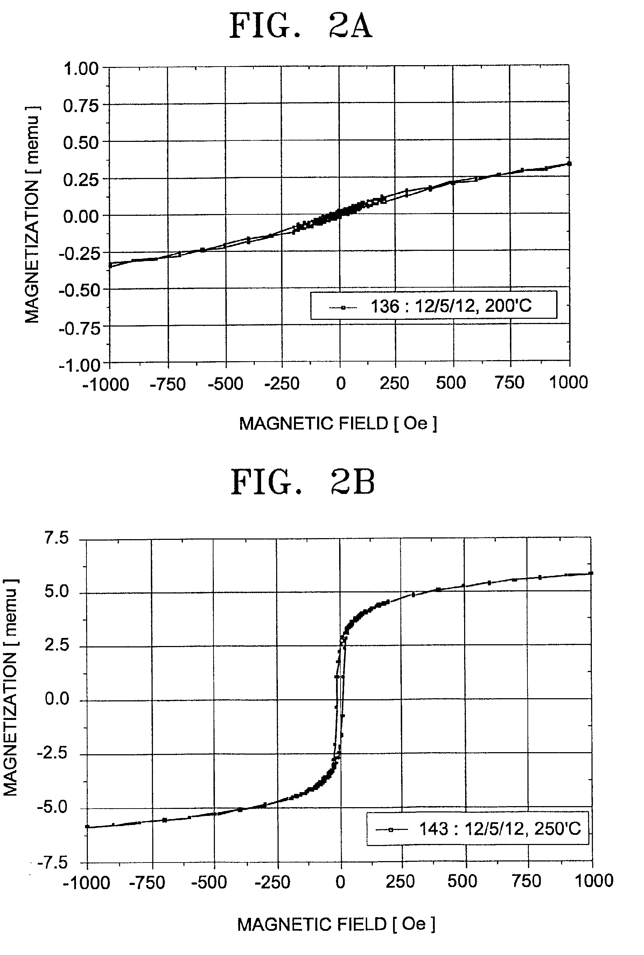

FIGS. 2A through 2D are graphs showing magnetic characteristics of a Heusler alloy thin film manufactured by co-sputtering based on changes in temperature of a substrate, which are measured using a VSM apparatus, according to the present invention.

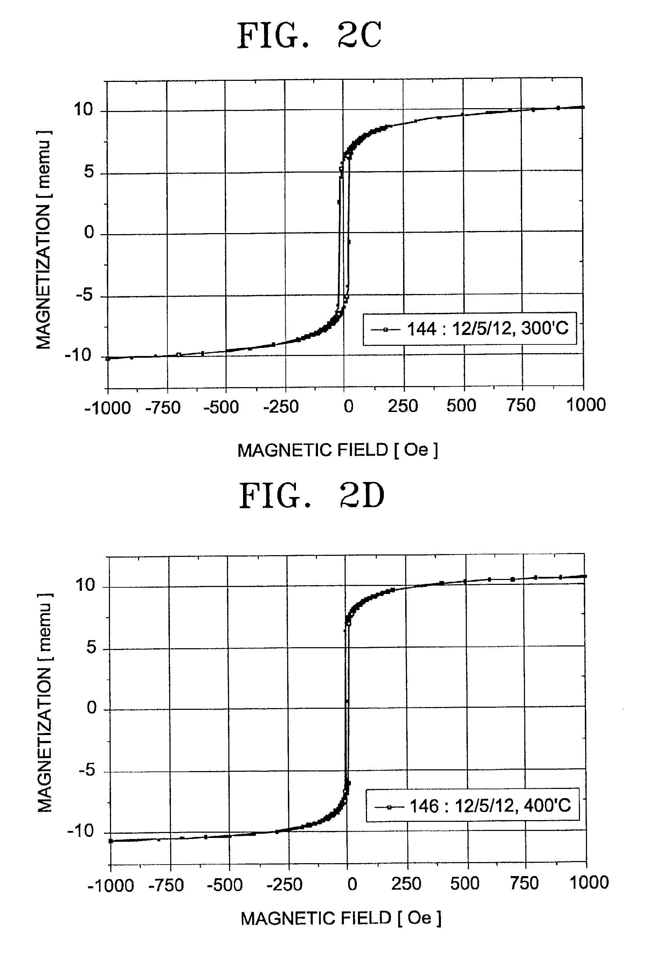

In FIG. 2A, a Heusler thin film is deposited on a substrate having a temperature of about 200°C for about 20 minutes. Here, it can be seen that the Heusleralloy thin film does not have magnetic characteristics which may be used in a MRAM. In FIG. 2B, a Heusleralloy thin film is deposited on a substrate having a temperature of about 250°C for about 20 minutes. Here, it can be seen that the Heusler alloy thin film have distinct magnetic characteristics and a considerably increased magnetization value compared to the Heusleralloy thin film deposited at the temperature of about 200°C. In FIG. 2C, a Heusleralloy thin film is deposited on a substrate having a temperature of about 300°C for about 20 minutes. It can be seen that the Heusler alloy thin film has a greater magnetization value than the Heusler alloy thin film in FIG. 2B. In FIG. 2D, a Heusler alloy thin film is deposited on a substrate having a temperature of about 400°C for about 20 minutes. It can be seen that the Heusler alloy thin film has the most increased saturation magnetization value.

Here, the distance between the substrate and targets in the deposition of the Heusler alloy thin film is about 10cm. Only temperature of the substrate varies and other conditions are the same when depositing each Heusler alloy thin film. Thus, the Heusler alloy thin films deposited on the substrates are the same.

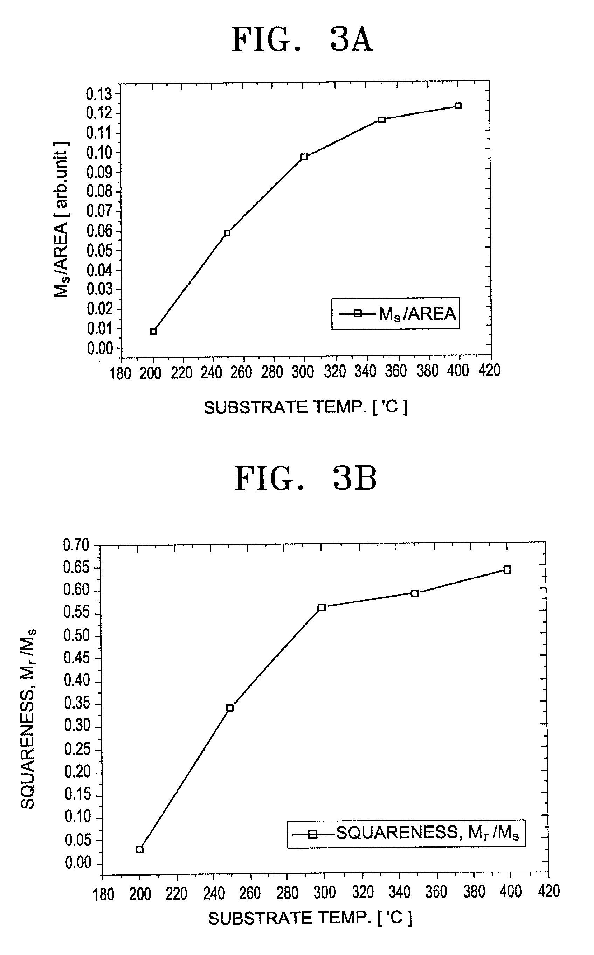

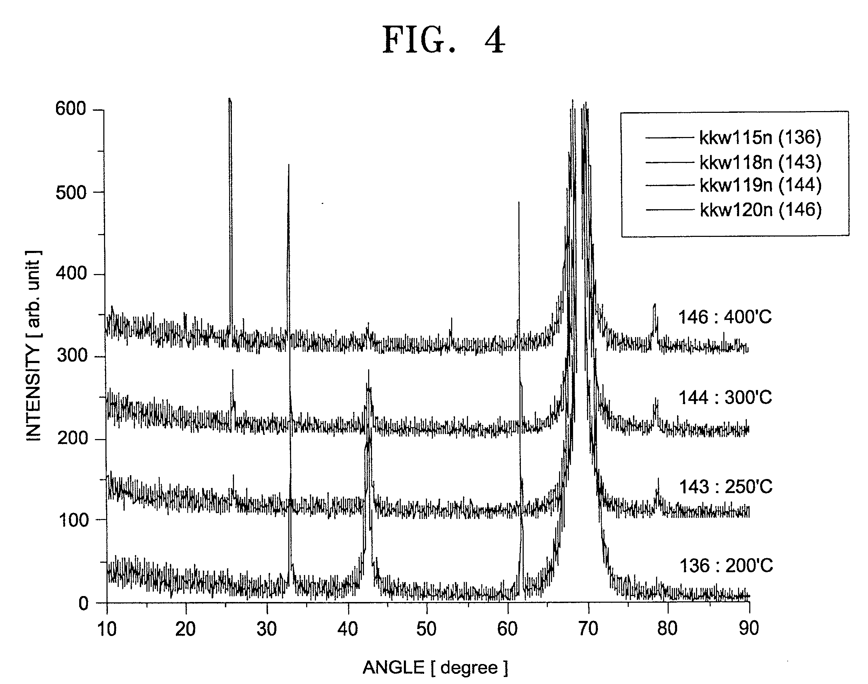

FIGS. 3A and 3B are graphs showing Ms/Area values and Mr/Ms values of a Heusler alloy thin film based on temperature of a substrate according to the present invention. Here, Ms values represent saturation magnetization values, Mr values represent remaining magnetization values, and Area represents the area of a substrate. Referring to FIGS. 3A and 3B, it can be seen that magnetic characteristics are more improved with an increase in the temperature. The magnetization characteristics of a Heusleralloy thin film deposited on a substrate having a temperature of about 250°C are more greatly improved than a Heusler alloy thin film deposited on a substrate having a temperature of about 200°C. The magnetization characteristics of the Heusler alloy thin film decrease with an increase in the temperature of the substrate. The magnetization characteristics of the Heusler alloy thin film deposited on a substrate having a temperature of about 350°C are not greatly improved as the temperature of the substrate increases. FIG. 4 is a graph showing X-ray diffraction measured with respect to a Heusler alloy thin film manufactured by changing a substrate temperature according to the present invention. Characteristics of a Hesuler alloy thin film based on a process temperature will be described in more detail with reference to FIG. 4. In FIG. 4, peaks occurring near to about 33, 62, and 68° represent characteristic peaks of a silicon substrate. Peak occurring near to about 26° represents superlattice peak. Peak occurring near to about 42° represents peak showing that components in a crystal structure of Heusler alloy are disordered. Here, intensity values when a substrate temperature is 250, 300, and 400°C, respectively, are transferred by a 100 unit in a y-axis direction for easy comparison. In other words, intensity values in a base section except for characteristic peaks are almost the same. In general, if supperlattic peak occurs, it is known that the Heusler alloy thin film has excellent characteristics as a magnetic thin film. Here, supperlattice peak near to about 26° stands out as the temperature of the substrate increases and peak near to about 42° showing disorder of the crystal structure of the Heusler thin film decreases.

According to the present invention, it is easy to manufacture a Heusler alloy thin film having excellent magnetic characteristics. A co-sputtering deposition method can easily vary depending on changes in components constituting the Heusler alloy thin film and composition. The Heusler alloy thin film can obtain characteristics such as a high MR rate and thus is easily adopted in the manufacture of a MRAM. As a result, a MRAM having an excellent efficiency can be provided. Uniformity tolerance, reliability, and yield can be improved in the manufacture of the MRAM. Also, if the Heusler alloy thin film is adopted in a magnetoresistant memory device of the MRAM, a signal-to-noise (S/N) ratio and sensing margin increase and a reduction in the MR rate occurring due to a bias voltage dependence degree of the MR rate can decrease.

## Claims

1. A method of manufacturing a Heusler alloy thin film having one of structure formulae X2YZ and XYZ by co-sputtering using a deposition apparatus having a substrate placed on a substrate holder in a chamber and targets positioned on a target bracket spaced apart from the substrate,
wherein components of the Heusler alloy thin film are placed on the target bracket as one of single targets and binary alloy targets.

2. The method of claim 1, wherein the substrate holder is maintained at a temperature of 200 - 500°C.

3. The method of claim 1 or 2, wherein the chamber is maintained in a vacuum of 10⁻² -10⁻³ Torr.

4. The method of any of claims 1 to 3, wherein the distance between the substrate and the targets is within a range of 5 - 20 cm.

5. The method of any of claims 1 to 4, wherein in the structure formula X2YZ of the Heusler alloy thin film, X is one of Co, Cu, Ni, Fe-based metals; Y is Mn or Ti, and Z is one of Al, Si, Ga, Ge, Sn, and Sb that is a nonmagnetic material of one of 3A and 4A groups of the Periodic Table.

6. The method of any of claims 1 to 4, wherein the structure formula XYZ of the Heusler alloy thin film is one of PtMnSb and NiMnSb.
